# EUROPEAN PATENT SPECIFICATION

(11) **EP 2 262 014 B1**
(45) Date of publication and mention of the grant of the patent: **19.04.2017**
(21) Application number: 10165236.0
(22) Date of filing: 08.06.2010
(51) Int. Cl.: H01L 33/00, H01L 33/32, H01L 33/40, H01L 33/44, H01L 33/20

(54) **Light emitting device and light emitting device package having the same**
Lichtemittierende Vorrichtung und Gehäuse für lichtemittierende Vorrichtung damit
Dispositif électroluminescent et boîtier l'incorporant

(30) Priority: 08.06.2009 KR 20090050403
(43) Date of publication of application: 15.12.2010
(73) Proprietor: LG Innotek Co., Ltd., Seoul 100-714 (KR)
(72) Inventor: Bae, Jung Hyeok, Gyeongsangnam-do (KR); Jeong, Young Kyu, Gwangju (KR)
(74) Representative: Cabinet Plasseraud

(56) References cited:
- EP-A1- 0 977 277
- EP-A1- 1 956 663
- JP-A- H 088 458
- JP-A- 2000 068 593
- JP-A- 2004 281 863
- US-A1- 2002 197 764
- US-A1- 2006 065 901
- US-A1- 2008 217 634

## Description

### BACKGROUND

Embodiments relate to a light emitting device, a light emitting device package, and a lighting system using the same.

Group III-V nitride semiconductors are getting the spotlight as core materials of light emitting devices such as a light emitting diode (LED), a laser diode (LD), etc. due to their physical and chemical properties. A Group III-V nitride semiconductor is typically made of semiconductor material having a compositional formula of InₓAl_{y}Ga_{1-x-y}N (0≤x≤1, 0≤y≤1, 0≤x+y≤1).

A light emitting diode (LED) is one type of semiconductor devices, which receives or transmits a signal by converting the electricity to infrared ray or light using the characteristics of semiconductor, or is used as light source.

LEDs or LDs using such a nitride semiconductor material are mainly used in light emitting devices for obtaining light, or are being applied as light sources for various devices such as a key pad light emitting part of a mobile phone, an electronic sign, a lighting apparatus, a display apparatus, and the like.

A light emitting device including an insulating member disposed on a side surface, an upper side, and a lower side of an active layer is known from JP 2000 068593 A. A light emitting device including an insulating layer disposed on the side surfaces and the top periphery of the light emitting diode region is known from US2006065901 A1.

### BRIEF SUMMARY

Embodiments provide a light emitting device with a novel structure.

Embodiments provide a light emitting device with an improved reliability, a light emitting device package, and a lighting system using the same.

In one embodiment, a light emitting device according to claim 1 is provided.

In a further embodiment, a light emitting device package according to claim 15 is provided.

### BRIEF DESCRIPTION OF THE DRAWINGS

FIG. 1 is a side sectional view of a light emitting device according to a first embodiment.
FIGs. 2 through 15 are cross-sectional views illustrating a method for manufacturing the light emitting device of FIG. 1.
FIG. 16 is a side sectional view of a light emitting device according to a second embodiment.
FIG. 17 is a side sectional view of a light emitting device according to a third embodiment.
FIG. 18 is a side sectional view of a light emitting device according to a fourth embodiment.
FIG. 19 is a side sectional view of a light emitting device according to a fifth embodiment.
FIG. 20 is a cross-sectional view of a light emitting device package provided with the light emitting device of FIG. 1.
FIG. 21 is a perspective view illustrating an example of a display apparatus provided with the light emitting device package of FIG. 20.
FIG. 22 is a perspective view illustrating another example of a display apparatus provided with the light emitting device package of FIG. 20.
FIG. 23 is a perspective view of a lighting apparatus provided with the light emitting device package of FIG. 20.

### DETAILED DESCRIPTION OF THE EMBODIMENTS

In the description of embodiments, it will be understood that when a layer (or film), region, pattern or structure is referred to as being 'on' another layer (or film), region, pad or pattern, the terminology of 'on' and 'under' includes both the meanings of 'directly' and 'indirectly'. Further, the reference about 'on' and 'under' each layer will be made on the basis of drawings.

The present disclosure will now be described more fully with reference to the accompanying drawings, in which exemplary embodiments of the present disclosure are shown. In the drawings, the thickness or size of each layer is exaggerated, omitted, or schematically illustrated for convenience in description and clarity. Also, the size of each element does not entirely reflect an actual size.

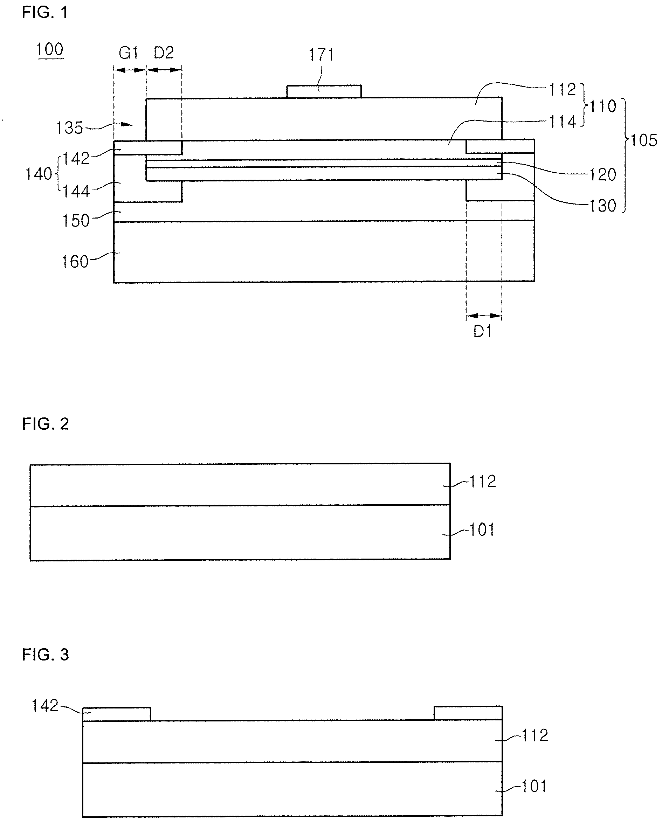

FIG. 1 is a side sectional view of a light emitting device according to a first embodiment.

Referring to FIG. 1, the light emitting device 100 includes a light emitting structure 105, an insulating member 140, an electrode layer 150, and a conductive supporting member 160.

The light emitting structure 105 may include Group III-V compound semiconductor, and may emit light having a visible ray wavelength and/or an ultraviolet wavelength. The light emitting structure 105 may include semiconductor material having a compositional formula of InₓAl_{y}Ga_{1-x-y}N (0≤x≤1, 0≤y≤1, 0≤x+y≤1), and the semiconductor material may be preferably selected from the group consisting of GaN, InN, AIN, InGaN, AlGaN, InAlGaN, AlInN, AlGaAs, InGaAs, AlInGaAs, GaP, AlGaP, InGaP, AlInGaP, and InP.

The light emitting structure 105 includes a first conductive (conductivity) type semiconductor layer 110, an active layer 120, and a second conductive type semiconductor layer 130. The first conductive type semiconductor layer 110 is formed on the active layer 120, and the second conductive type semiconductor layer 130 is formed under the active layer 120.

The first conductive type semiconductor layer 110 may include Group III-V compound semiconductor including a first conductive type dopant, for example, a semiconductor material having a compositional formula of InₓAl_{y}Ga_{1-x-y}N (0≤x≤1, 0≤y≤1, 0≤x+y≤1), and the semiconductor material may be preferably selected from the group consisting of GaN, AIN, AlGaN, InGaN, InN, InAlGaN, AlInN, AlGaAs, GaP, GaAs, GaAsP, and AlGaInP. In the case where the first conductive type semiconductor layer 110 is an N-type semiconductor layer, the first conductive type dopant is an N-type dopant, and includes Si, Ge, Sn, Se, and Te.

The first conductive type semiconductor layer 110 includes a plurality of layers. The first conductive type semiconductor layer 110 includes a first semiconductor layer 112, and a second semiconductor layer under the first semiconductor layer 112. The first semiconductor layer 112 may have a dopant concentration which is substantially the same as or different from that of the second semiconductor layer 114. For example, when the first semiconductor layer 112 is doped with a conductive type dopant, the doping concentration of the conductive type dopant may be the same as or lower than that of the doping concentration of the second semiconductor layer 114. Herein, in the case where the dopant concentration of the first semiconductor layer 112, e.g., the N-type dopant concentration is low, the first semiconductor layer 112 may diffuse current applied to the first semiconductor layer 112. The first semiconductor layer 112 may be doped at a doping concentration lower than that of the second semiconductor layer 114 or may be undoped.

The first semiconductor layer 112 and the second semiconductor layer 114 may be formed of the same semiconductor material or different semiconductor materials, but the present disclosure is not limited thereto. For example, the first semiconductor layer 112 and the second semiconductor layer 114 may be formed of any one of GaN, AIN, AlGaN, InGaN, InN, InAlGaN, AlInN, AlGaAs, GaP, GaAs, GaAsP, and AlGaInP. Also, the first semiconductor layer 112 may be an AlGaN layer or AIN layer and the second semiconductor layer 114 may be a GaN layer, but the present disclosure is not limited thereto. The first semiconductor layer 112 and the second semiconductor layer 114 may be formed of materials having different refractive indexes. For example, the first semiconductor layer 112 may be formed of a material having a high refractive index, and the second semiconductor layer 114 may be formed of a material having a low refractive index. The difference in the material or refractive index between the first semiconductor layer 112 and the second semiconductor layer 114 may improve diffusion of current or light extraction.

An electrode 171 is formed on the first conductive type semiconductor layer 110. The electrode 171 may contact an upper surface of the first semiconductor layer 112, and includes a metal material. The electrode 171 may be formed in a single layer structure or a multi-layer structure, and may include at least one selected from the group consisting of Ag, Ni, Al, Rh, Pd, Ir, Ru, Mg, Zn, Pt, Au, Hf, Ti, Cr, and Cu. The electrode 171 may include a pad or a pad including an electrode pattern. The pad may be disposed on the first semiconductor layer 112 or on another portion, but the present disclosure is not limited thereto. In an example falling outside the scope of the invention, the electrode 171 may not be disposed on the first semiconductor layer 112, but be disposed on another portion, but the present disclosure is not limited thereto.

A width of lower surface of the first semiconductor layer 112 may be greater than a width of an upper surface of the second semiconductor layer 114, and the width of the upper surface of the second semiconductor layer 114 may be less than the width of lower surface of the second semiconductor layer 114. An outer periphery of the second semiconductor layer 114 may be formed in a stepwise structure.

An upper surface of the first semiconductor layer 112 may have a roughness pattern or irregular pattern, which can improve light extracting efficiency.

An active layer 120 is formed under the first conductive type semiconductor layer 110. The active layer 120 may include a Group III-V compound semiconductor, and may include two materials having different band gaps. The active layer 120 may include a pair of well layer and barrier layer, which may be formed in 1 to 30 periods. The active layer 120 may be formed of one selected from the group consisting of GaN, AIN, AlGaN, InGaN, InN, InAlGaN, AlInN, AlGaAs, GaP, GaAs, GaAsP, and AlGaInP.

The active layer 120 may be formed in at least one of a single quantum well structure, a multi quantum well (MQW) structure, a quantum-wire structure, and a quantum dot structure. For example, the active layer 120 may be formed in at least one pair structure of InGaN well layer/GaN barrier layer, InGaN well layer/InGaN barrier, GaN well layer/GaN barrier layer, or the like. The barrier layer may be formed of a material having a band gap which is greater than that of the well layer.

A conductive clad layer (not shown) may be formed on or/and under the active layer 120. The conductive clad layer may be formed of one selected from semiconductor materials having a compositional formula of InₓAl_{y}Ga_{1-x-y}N (0≤x≤1, 0≤y≤1, 0≤x+y≤1), for example, may be formed of GaN-based semiconductor. The conductive clad layer may be formed of a material having a band gap which is greater than that of the barrier layer.

A second conductive type semiconductor layer 130 is formed under the active layer 120. The second conductive type semiconductor layer 130 may include III-V compound semiconductor, for example, semiconductor material having a compositional formula of InₓAl_{y}Ga_{1-x-y}N (0≤1, 0≤y≤1, 0≤x+y≤1). The semiconductor material may be preferably selected from GaN, AIN, AlGaN, InGaN, InN, InAlGaN, AlInN, AlGaAs, GaP, GaAs, GaAsP, and AlGaInP. The second conductive type semiconductor layer 130 may be formed in a single layer or a multi-layer.

In the case where the second conductive type semiconductor layer 130 is a P-type semiconductor layer, the second conductive type dopant may include a P-type dopant such as Mg, Zn, Ca, Sr, or Ba.

While the current embodiment describes that the first conductive type semiconductor layer 110 of the light emitting structure 105 is an N-type semiconductor layer and the second conductive type semiconductor layer 130 is a P-type semiconductor layer, an opposite case will be possible. For example, the first conductive type semiconductor layer 110 may be implemented by a P-type semiconductor and the second conductive type semiconductor layer 130 may be implemented by an N-type semiconductor layer. Alternatively, a third conductive type semiconductor layer may be formed under the second conductive type semiconductor layer 130. The third conductive type semiconductor layer may be implemented by a semiconductor layer having an opposite conductive type to the second conductive semiconductor layer, for example, an N-type semiconductor layer. The light emitting structure 105 may be implemented by at least one of an N-P junction, a P-N junction, an N-P-N junction, and a P-N-P junction.

The insulating member 140 is disposed on an outer periphery of the light emitting structure 105. The insulating member 140 includes a first insulating layer 142 and a second insulating layer 144. The insulating member 140 may be formed of an insulating material, for example, at least one selected from the group consisting of SiO₂, SiOₓ, SiOₓN_{y}, Si₃N₄, Al₂O₃, and TiO₂.

An inner portion of the first insulating layer 142 is formed on an outer periphery of the second semiconductor layer 114 between the first semiconductor layer 112 and the second semiconductor layer 114. The first insulating layer 142 and the second insulating layer 144 are made of the same material. An outer portion of upper surface of the first insulating layer 142 may extend to an outside of the first semiconductor layer 112 and be exposed. A lower surface of outer portion of the first insulating layer 142 is formed on the second insulating layer 144. An upper surface and a side surface of the first semiconductor layer 112 do not physically contact the first insulating layer 142, but are separated from the first insulating layer 142.

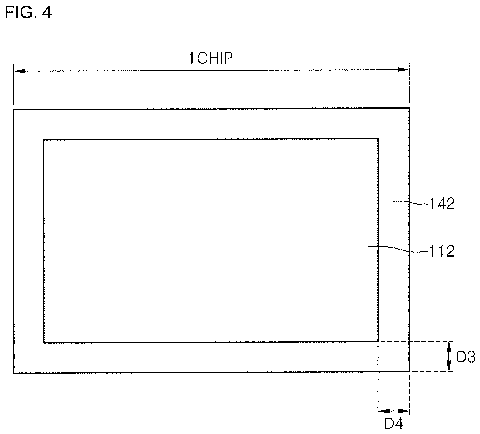

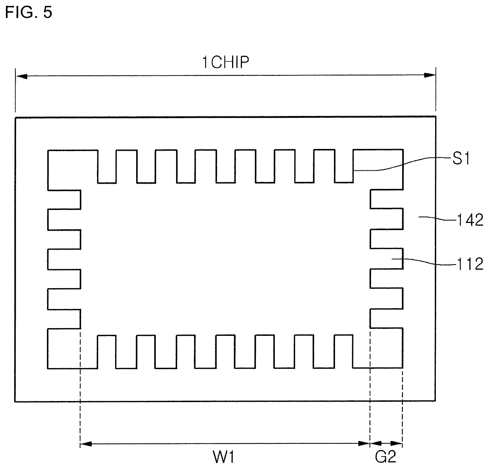

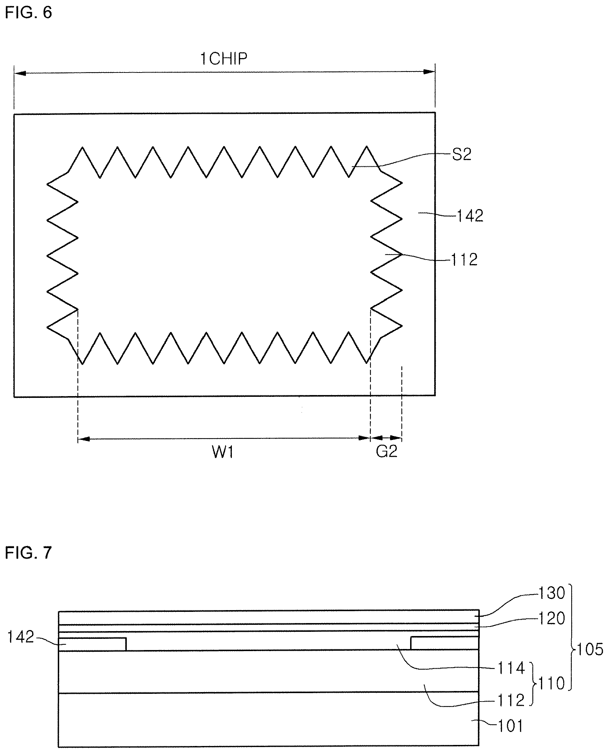

The first insulating layer 142, in examples falling outside the scope of the invention, may include a frame shape as shown in FIG. 4, a ring shape, and a loop shape; it may be disposed in a continuous shape. An inner side surface of the first insulating layer 142 has a concavo-convex surface S1, S2 as shown in FIGs. 5 and 6. surface S1, S2 as shown in FIGs. 5 and 6. The concavo-convex surface S1, S2 may include a polygonal shape or a semi-spherical shape. For example, the concavo-convex surface S1, S2 may include rectangular concave portions and rectangular convex portions formed alternatingly, or may include triangular concave portions and triangular convex portions formed alternatingly, but the present disclosure is not limited thereto.

For the concavo-convex surface S1, S2 of the first insulating layer 142, since it is possible to allow current to flow to the concave portion, concentration of current can be prevented.

The second insulating layer 144 is formed on outer periphery of the second semiconductor layer 114, the active layer 120 and the second conductive type semiconductor layer 130, to cover the outer periphery of the second semiconductor layer 114, the active layer 120 and the second conductive type semiconductor layer 130. An inner portion of lower part of the second insulating layer 144 may extend between the second conductive type semiconductor layer 130 and the electrode layer 150, and thus contacts a lower part of the second conductive type semiconductor layer 130.

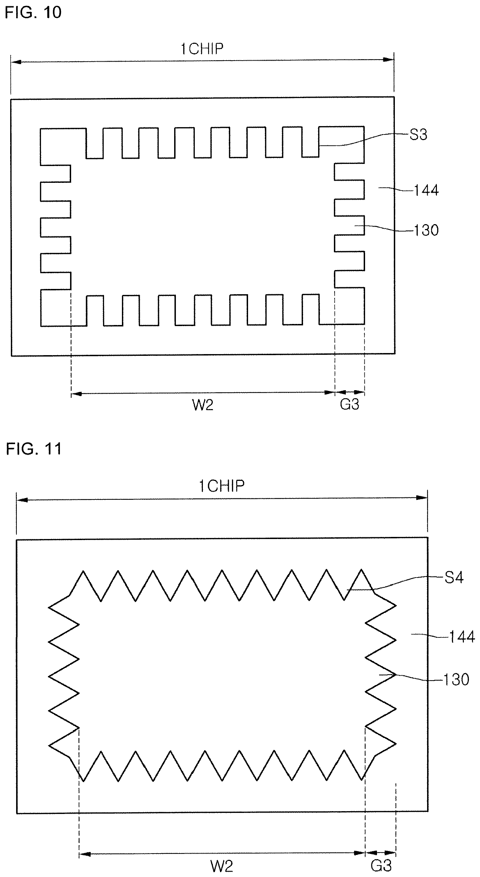

The second insulating layer 144 may include a frame shape, a ring shape, and a loop shape. The second insulating layer 144 may be disposed in a continuous shape. Also, an inner side surface of the second insulating layer 144 may have a cancavo-convex surface S3, S4 as shown in FIGs. 10 and 11. The cancavo-convex surface S3, S4 may include a polygonal shape or a semi-spherical shape. For example, the cancavo-convex surface S3, S4 may include rectangular concave portions and rectangular convex portions formed alternatingly, or may include triangular concave portions and triangular convex portions formed alternatingly, but the present disclosure is not limited thereto.

In the case of the cancavo-convex surface S3, S4 of the second insulating layer 144, since it is possible to allow current to flow to the concave portion, concentration of current can be prevented. Herein, the first insulating layer 142 and the second insulating layer 144 may be designed such that the concave portion of the second insulating layer 144 faces the concave portion of the first insulating layer 142 or in a cross each other.

The inner portion of lower part of the second insulating layer 144 may partially overlap the inner portion of the first insulating layer 142 in a vertical direction. The inner width D1 of the first insulating layer 142 may be equal to or less than the inner width D2 of the second insulating layer 144, but the present disclosure is not limited thereto.

The inner portion of the first insulating layer 142 can improve an adhesive force between the first semiconductor layer 112 and the second semiconductor layer 114, and the inner portion of lower part of the second insulating layer 144 can improve an adhesive force between the second conductive type semiconductor layer 130 and the electrode layer 150.

Since the first semiconductor layer 112 is exposed at the upper surface and periphery of the light emitting structure 105, partial light intensity loss problem can be improved.

The insulating member 140 is formed on sidewalls of the second semiconductor layer 114, the active layer 120 and the second conductive type semiconductor layer 130. Therefore, by insulating the sidewalls of the second semiconductor layer 114, the active layer 120 and the second conductive type semiconductor layer 130, an interlayer short problem in the sidewall of the light emitting device can be solved. Also, the insulating member 140 can prevent moisture from being penetrated through the sidewall of the light emitting structure 105.

The electrode layer 150 is formed on lower surfaces of the second conductive type semiconductor layer 130 and the second insulating layer 144 of the insulating member 140.

The electrode layer 150 is disposed under the second conductive type semiconductor layer 130, and supplies power and reflects light. An outer portion of the electrode layer 150 extends under the second insulating layer 144. For example, the outer portion of the electrode layer 150 may extend so as to partially or completely cover the lower surface of the second insulating layer 144.

The electrode layer 150 may be formed of a metal material selected from the group consisting of Ag, Ni, Al, Rh, Pd, Ir, Ru, Mg, Zn, Pt, Au, Hf and combination thereof. Herein, the electrode layer 150 may include a metal material having a 50 % or more reflectivity.

The electrode layer 150 includes a reflective layer and may include at least one of an ohmic layer, and a seed layer. A low conductivity material may be formed in a pattern shape between the electrode layer 150 and the second conductive type semiconductor layer 130, but the present disclosure is not limited thereto.

The electrode layer 150 may include a material that is disposed on a metal material and is different from the metal material, for example, a transparent oxide or a transparent nitride. The material constituting the electrode layer 150 may include at least one selected from the group consisting of indium tin oxide (ITO), indium zinc oxide (IZO), IZO nitride (IZON), indium zinc tin oxide (IZTO), indium aluminum zinc oxide (IAZO), indium gallium zinc oxide (IGZO), indium gallium tin oxide (IGTO), aluminum zinc oxide (AZO), antimony tin oxide (ATO), gallium zinc oxide (GZO), IrOx, RuOx, RuOx/ITO, Ni, Ag, Ni/IrOx/Au, and Ni/IrOx/Au/ITO, but the present disclosure is not limited thereto.

The conductive supporting member 160 is formed under the electrode layer 150. The conductive supporting member 160 may selectively include copper (Cu), gold (Au), nickel (Ni), molybdenum (Mo), Cu-W, and carrier wafer such as Si, Ge, GaAs, ZnO, SiC. The conductive supporting member 160 may be formed in the form of a plated film, or in a sheet form, but the present disclosure is not limited thereto. Also, the electrode layer 150 and the conductive supporting member 160 may be formed of a single layer conductive material, but the present disclosure is not limited thereto.

While the embodiment describes that the light emitting device has the conductive supporting member 160, in an example falling outside the scope of the invention, an insulating substrate may be used instead of the conductive supporting member 160. In the case where the insulating substrate is used, the insulating substrate may be electrically connected to the electrode layer 150 through a side surface or a via structure.

FIGs. 2 to 15 are cross-sectional views illustrating a method for manufacturing the light emitting device of FIG. 1.

Referring to FIGs. 2 and 3, after a substrate 101 is loaded in a growth equipment, a first semiconductor layer 112 of a first conductive type semiconductor layer is formed on the substrate 101.

The substrate 101 may be selected from the group consisting of sapphire (Al₂0₃), GaN, SiC, ZnO, Si, GaP, InP, Ga₂O₃, and GaAs substrates. The growth equipment may include an electron beam evaporator, a physical vapor deposition (PVD), a chemical vapor deposition (CVD), a plasma laser deposition (PLD), a dual-type thermal evaporator, a sputtering, and a metal organic chemical vapor deposition (MOCVD), but the present disclosure is not limited thereto.

A buffer layer (not shown) and/or undoped semiconductor layer (not shown) may be formed on the substrate 101 by using Group III to Group VI compound semiconductor, and may be removed after growth of a thin layer. The buffer layer can decrease a difference in the lattice constant between the substrate 101 and a layer formed thereon, and may be made of any one of compound semiconductors, such as GaN, InN, AlN, InGaN, AlGaN, InAlGaN, and AlInN, but the present disclosure is not limited thereto.

The first semiconductor layer 112 includes a Group III-V compound semiconductor doped with a first conductive type dopant. The first semiconductor layer 112 may include a semiconductor material, for example, having a compositional formula of InₓAl_{y}Ga₁₋ₓ₋yN (0≤x≤1, 0≤y≤1, 0≤x+y≤1). The first semiconductor layer 112 may be formed of a material selected from the group consisting of GaN, AIN, AlGaN, InGaN, InN, InAlGaN, AlInN, AlGaAs, GaP, GaAs, GaAsP, and AlGaInP, and may be formed in a single layer or multi-layer.

In the case where the first semiconductor layer 112 is an N-type semiconductor layer, the first semiconductor layer 112 may be doped with an N-type dopant such as Si, Ge, Sn, Se, Te. Also, the first semiconductor layer 112 may be an undoped semiconductor layer or may include a lightly doped N-type dopant.

A first insulating layer 142 is formed on an upper periphery of the first semiconductor layer 112. The first insulating layer 142 may be formed at a region where a mask layer is not formed, but the present disclosure is not limited thereto.

FIG. 4 is an example of a plan view of the structure shown in FIG. 3, which falls outside the scope of the present invention. Referring to FIG. 4, the first insulating layer 142 may be disposed in a frame shape, a ring shape, a loop shape, or a continuous shape. The width D3 of the first insulating layer 142 in the lateral direction and the width D4 of the first insulating layer 142 in the longitudinal direction may have a range of 0.1 µm to 10 µm, and may be equal to or different from each other.

As shown in FIGs. 5 and 6, an inner side surface of the first insulating layer 142 has a concavo-convex surface S1, S2 in which concave portions and convex portions are repeated alternatingly. The concavo-convex surface S1, S2 may include a polygonal shape or a semi-spherical shape. For example, the concavo-convex surface S1, S2 may include rectangular concave portions and rectangular convex portions repeated alternatingly, or may include triangular concave portions and triangular convex portions formed alternatingly, but the present disclosure is not limited thereto.

The concavo-convex surface S1, S2 of the first insulating layer 142 can improve an adhesive force between the first semiconductor layer 112 and the second semiconductor layer 114, and can block concentration of current to allow current to be diffused.

The first insulating layer 142 may be formed of an insulating material, for example, selected from the group consisting of SiO₂, SiOₓ, SiOₓN_{y}, Si₃N₄, Al₂O₃, and TiO₂, but the present disclosure is not limited thereto.

Also, an upper surface of the first semiconductor layer 112 positioned inside the first insulating layer 142 is exposed, and the width W1 of the exposed upper surface of the first semiconductor layer 112 may be smaller than the width of the active layer. The first semiconductor layer 112 may further extend outwardly by the width W1 and partially by a gap G₂ of the concavo-convex surface S1, S2, but the present disclosure is not limited thereto.

Referring to FIGs. 3 and 7, a second semiconductor layer 114 is formed on the first semiconductor layer 112. The second semiconductor layer 114 may include a Group III-V compound semiconductor doped with a first conductive type dopant, and may include a semiconductor material, for example, having a compositional formula of InₓAl_{y}Ga_{1-x-y}N (0≤x≤1, 0≤y≤1, 0≤x+y≤1). The second semiconductor layer 114 may be preferably formed of a material selected from the group consisting of GaN, AIN, AlGaN, InGaN, InN, InAlGaN, AlInN, AlGaAs, GaP, GaAs, GaAsP, and AlGaInP, and may be formed in a single layer or multi-layer.

The first semiconductor layer 112 and the second semiconductor layer 114 are defined as a first conductive type semiconductor layer 110. The first semiconductor layer 112 and the second semiconductor layer 114 may be formed of the same semiconductor material or different semiconductor materials, but the present disclosure is not limited thereto.

The first conductive type semiconductor layer 110 includes the first semiconductor layer 112, and the second semiconductor layer 114 on the first semiconductor layer 112. The dopant concentrations of the first semiconductor layer 112 may be substantially equal to or different from the dopant concentration of the second semiconductor layer 114. For example, the dopant concentration of the first semiconductor layer 112 may be equal to or lower than the dopant concentration of the second semiconductor layer 114. Herein, in the case where the N-type dopant concentration of the first semiconductor layer 112 is lower than the N-type dopant concentration of the second semiconductor layer 114, it is possible to diffuse the current applied to the first semiconductor layer 112. The first semiconductor layer 112 may be doped at a lower concentration than the dopant concentration of the second semiconductor layer 114, or may be undoped.

The first semiconductor layer 112 and the second semiconductor layer 114 may be formed of any one material selected from the group consisting of GaN, AIN, AlGaN, InGaN, InN, InAlGaN, AlInN, AlGaAs, GaP, GaAs, GaAsP, and AlGaInP. Also, the first semiconductor layer 112 may be an AlGaN or AIN layer, and the second semiconductor layer 114 may be a GaN layer. The first semiconductor layer 112 and the second semiconductor layer 114 may be formed of materials having different refractive indexes. For example, the first semiconductor layer 112 may be formed of a material having a high refractive index, and the second semiconductor layer 114 may be formed of a material having a low refractive index. A difference in the material or refractive index between the first semiconductor layer 112 and the second semiconductor layer 114 can allow current to be diffused or light extraction to be improved.

The width of the upper surface of the first semiconductor layer 112 may be greater than the width of the lower surface of the second semiconductor layer 114, and the width of the upper surface of the second semiconductor layer 114 may be smaller than the width of the lower surface of the second semiconductor layer 114. A lower periphery of the second semiconductor layer 114 may be formed in a stepwise structure.

An active layer 120 is formed on the first conductive type semiconductor layer 110. The active layer 120 may include a Group III-V compound semiconductor, and may include two materials having different band gaps. The active layer 120 may include a pair of well layer and barrier layer, which may be formed in 1 to 30 periods. The active layer 120 may be formed of one selected from the group consisting of GaN, AIN, AlGaN, InGaN, InN, InAlGaN, AlInN, AlGaAs, GaP, GaAs, GaAsP, and AlGaInP.

The active layer 120 may be formed in at least one of a single quantum well structure, a multi quantum well (MQW) structure, a quantum-wire structure, and a quantum dot structure. For example, the active layer 120 may be formed in a pair structure of InGaN well layer/GaN barrier layer, InGaN well layer/InGaN barrier, GaN well layer/GaN barrier layer, or the like. The barrier layer may be formed of a material having a band gap which is greater than that of the well layer.

A conductive clad layer (not shown) may be formed on or/and under the active layer 120. The conductive clad layer may be formed of one selected from semiconductor materials having a compositional formula of InₓAl_{y}Ga_{1-x-y}N (0≤x≤1, 0≤y≤1, 0≤x+y≤1), for example, may be formed of GaN-based semiconductor. The conductive clad layer may be formed of a material having a band gap which is greater than that of the barrier layer.

A second conductive type semiconductor layer 130 is formed on the active layer 120. The active layer 120, the second semiconductor layer 114 and the second conductive type semiconductor layer 130 may be formed with the same width.

The second conductive type semiconductor layer 130 may include III-V compound semiconductor, for example, semiconductor material having a compositional formula of InₓAl_{y}Ga_{1-x-y}N (0≤x≤1, 0≤y≤1, 0≤x+y≤1). The semiconductor material may be preferably selected from GaN, AIN, AlGaN, InGaN, InN, InAlGaN, AlInN, AlGaAs, GaP, GaAs, GaAsP, and AlGaInP. The second conductive type semiconductor layer 130 may be formed in a single layer or a multi-layer.

In the case where the second conductive type semiconductor layer 130 is a P-type semiconductor layer, the second conductive type dopant may include a P-type dopant such as Mg, Zn, Ca, Sr, Ba.

The first conductive type semiconductor layer 110, the active layer 120 and the second conductive type semiconductor layer 130 are defined as a light emitting structure 105. While the current embodiment describes that the first conductive type semiconductor layer 110 of the light emitting structure 105 is an N-type semiconductor layer and the second conductive type semiconductor layer 130 is a P-type semiconductor layer, an opposite case will be possible. For example, the first conductive type semiconductor layer 110 may be implemented by a P-type semiconductor and the second conductive type semiconductor layer 130 may be implemented by an N-type semiconductor layer. Alternatively, a third conductive type semiconductor layer may be formed under the second conductive type semiconductor layer 130. The third conductive type semiconductor layer may be implemented by a semiconductor layer having an opposite conductive type to the second conductive semiconductor layer, for example, an N-type semiconductor layer. The light emitting structure 105 may be implemented by at least one of an N-P junction, a P-N junction, an N-P-N junction, and a P-N-P junction.

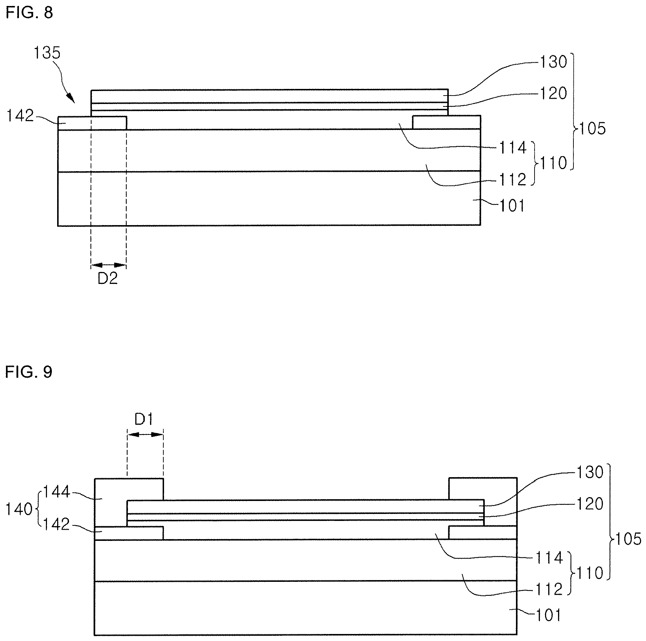

Referring to FIGs. 7 and 8, a first etching process is performed to expose an outer upper surface of the first insulating layer 142. By the first etching process, outer circumferential portions of the second conductive type semiconductor layer 130, the active layer 120 and the second semiconductor layer 114 are etched. Therefore, an outer circumferential portion of the light emitting structure 105, i.e., a channel region 135 is removed, so that an outer upper surface of the first insulating layer 142 is exposed. That is, the first etching process may include a dry or/and wet etching process, but the present disclosure is not limited thereto.

An inner portion of the first insulating layer 142 is formed on an outer periphery of the second semiconductor layer 114 between the first semiconductor layer 112 and the second semiconductor layer 114.

Referring to FIGS. 8 and 9, a second insulating layer 144 is formed on the first insulating layer 142. The second insulating layer 144 may be formed of an insulating material, for example, selected from the group consisting of SiO₂, SiOₓ, SiOₓN_{y}, Si₃N₄, Al₂O₃, and TiO₂. The first insulating layer 142 and the second insulating layer 144 may be defined as an insulating member 140.

The second insulating layer 144 of the insulating member 140 covers outer side surfaces of the second semiconductor layer 114, the active layer 120 and the second conductive type semiconductor layer 130. An upper portion of the second insulating layer extends around an upper surface of the second conductive type semiconductor layer 130.

The second insulating layer 144 may include a frame shape, a ring shape, and a loop shape. The second insulating layer 144 may be disposed in a continuous shape. Also, an inner surface of the second insulating layer 144 may have a cancavo-convex surface S3, S4 as shown in FIGs. 10 and 11. The cancavo-convex surface S3, S4 may include a polygonal shape or a semi-spherical shape. For example, the cancavo-convex surface S3, S4 may include rectangular concave portions and rectangular convex portions formed alternatingly, or may include triangular concave portions and triangular convex portions formed alternatingly, but the present disclosure is not limited thereto.

In the case of the cancavo-convex surface S3, S4 of the second insulating layer 144, since it is possible to allow current to flow to the concave portion, concentration of current can be prevented. Herein, the first insulating layer 142 and the second insulating layer 144 may be designed such that the concave portion of the second insulating layer 144 faces the concave portion of the first insulating layer 142 or in a cross each other.

The lower inner portion of the second insulating layer 144 may partially overlap the inner portion of the first insulating layer 142 in a vertical direction.

The insulating member 140 is formed on sidewalls of the second semiconductor layer 114, the active layer 120 and the second conductive type semiconductor layer 130. Therefore, by insulating the sidewalls of the second semiconductor layer 114, the active layer 120 and the second conductive type semiconductor layer 130, an interlayer short problem in the sidewall of the light emitting device can be solved. Also, the insulating member 140 can prevent moisture from being penetrated through the sidewall of the light emitting structure 105.

Also, by minimizing the covering region of the insulating member 140 in the light emitting structure 105, light intensity loss can be decreased. Since the insulating member 140 is disposed on/under the light emitting structure 105, stability from the substrate removing process can be secured.

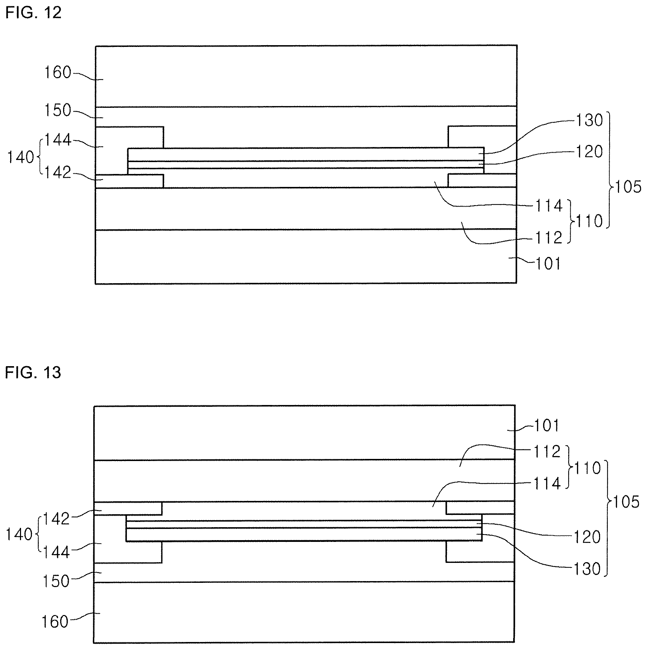

As shown in FIG. 12, an electrode layer 150 is formed on the second conductive type semiconductor layer 130, and a conductive supporting member 160 is formed on the electrode layer 150.

The electrode layer 150 extends on some or all of the upper surface of the second insulating layer 144.

The inner portion of the first insulating layer 142 can improve an adhesive force between the first semiconductor layer 112 and the second semiconductor layer 114, and the inner portion of lower part of the second insulating layer 144 can improve an adhesive force between the second conductive type semiconductor layer 130 and the electrode layer 150.

Since the first semiconductor layer 112 is exposed at the upper surface and periphery of the light emitting structure 105, partial light intensity loss problem can be improved.

The electrode layer 150 is electrically connected to the second conductive type semiconductor layer 130, and reflects light.

The electrode layer 150 may be formed of a metal material selected from the group consisting of Ag, Ni, Al, Rh, Pd, Ir, Ru, Mg, Zn, Pt, Au, Hf and combination thereof. Herein, the electrode layer 150 may include a metal material having a 50 % or more reflectivity.

The electrode layer 150 includes a reflective layer and may include at least one of an ohmic layer, and a seed layer. A low conductivity material may be formed in a pattern shape between the electrode layer 150 and the second conductive type semiconductor layer 130, but the present disclosure is not limited thereto.

The electrode layer 150 may include a material which is different from the metal material, for example, a transparent oxide or a transparent nitride. The material constituting the electrode layer 150 may include at least one selected from the group consisting of indium tin oxide (ITO), indium zinc oxide (IZO), IZO nitride (IZON), indium zinc tin oxide (IZTO), indium aluminum zinc oxide (IAZO), indium gallium zinc oxide (IGZO), indium gallium tin oxide (IGTO), aluminum zinc oxide (AZO), antimony tin oxide (ATO), gallium zinc oxide (GZO), IrOx, RuOx, RuOx/ITO, Ni, Ag, Ni/IrOx/Au, and Ni/IrOx/Au/ITO, but the present disclosure is not limited thereto.

A conductive supporting member 160 is formed on the electrode layer 150. The conductive supporting member 160 may selectively include copper (Cu), gold (Au), nickel (Ni), molybdenum (Mo), Cu-W, and carrier wafer such as Si, Ge, GaAs, ZnO, SiC. The conductive supporting member 160 may be formed in the form of a plated film, or in a sheet form, but the present disclosure is not limited thereto. Also, the electrode layer 150 and the conductive supporting member 160 may be formed of a single layer conductive material, but the present disclosure is not limited thereto.

While the embodiment describes that the light emitting device has the conductive supporting member 160, in examples falling outside the scope of the invention, an insulating substrate may be used instead of the conductive supporting member 160. In the case where the insulating substrate is used, the insulating substrate may be electrically connected to the electrode layer 150 through a side surface or a via structure.

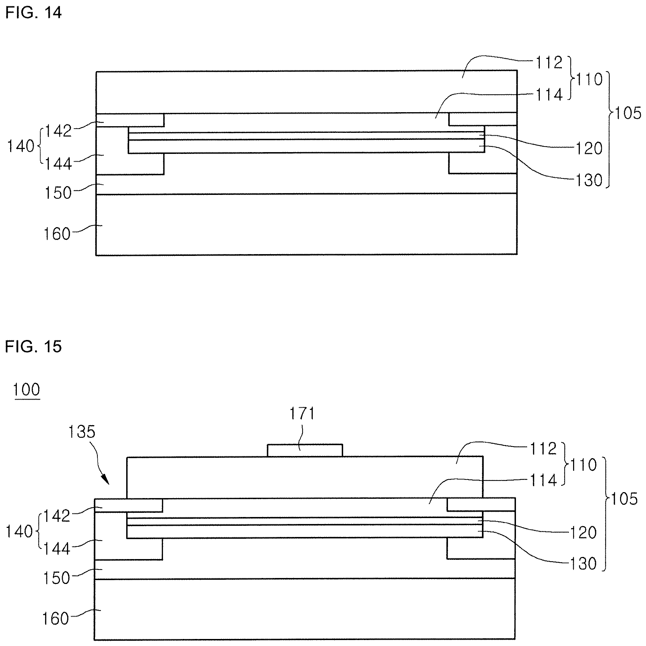

Referring to FIGs. 13 and 14, after the conductive supporting member 160 is formed, the conductive supporting member 160 is disposed on a base, and then the substrate 101 is removed. The removing of the substrate 101 may be performed by a physical or/and chemical removing method.

The physical removing method may include a laser lift off (LLO) method in which the substrate 101 is removed by irradiating laser beam having a predetermined wavelength. In the chemical removing method, by injecting a wet etchant into a semiconductor layer space (e.g., buffer layer), the substrate 101 may be removed.

As the substrate 101 is removed, the first semiconductor layer 112 is exposed as shown in FIG. 14.

Referring to FIG. 15, after the substrate 101 is removed, a second etching process is performed to etch a channel region (or chip boundary region) and thus divide the light emitting structure into chip units. At this time, the outer circumferential portion of the first semiconductor layer 112 is etched, so that the upper surface of the insulating member 140 is exposed. The etching method may include a dry etching and/or a wet etching.

When the second etching process is a wet etching process, the etching of the channel region is performed by irradiating laser beam. At this time, since the outer circumferential portion of the first semiconductor layer 112 is etched, the laser beam transmits the insulating member 140. At this time, the insulating member 140 may protect the outer wall of the light emitting structure 105 to prevent an interlayer short problem.

An inductively coupled plasma/reactive ion etching (ICP/RIE) may be further performed with respect to the upper surface of the first semiconductor layer 112, but the present disclosure is not limited thereto.

A roughness or uneven pattern may be formed at the upper surface of the first semiconductor layer 112 constituting the first conductive type semiconductor layer 110.

An electrode 171 electrically contacts the first semiconductor layer 112 of the first conductive type semiconductor layer 110. The electrode 171 may include a pad or a pad including an electrode pattern, which is formed on the first semiconductor layer 112, but the present disclosure is not limited thereto.

The electrode 171 may be formed before or after the second etching process, but the present disclosure is not limited thereto.

The electrode 171 may be formed in a single layer or a multi-layer, and may include at least one selected from the group consisting of Ag, Ni, Al, Rh, Pd, Ir, Ru, Mg, Zn, Pt, Au, Hf, Ti, Cr, and Cu. The electrode 171 may include a pad or a pad including an electrode pattern. The pad may be disposed on the first semiconductor layer 112 or on another portion, but the present disclosure is not limited thereto. In an example falling outside the scope of the invention, the electrode 171 may not be disposed on the first semiconductor layer 112, but be disposed on another portion, but the present disclosure is not limited thereto.

After the second etching process is completed, the light emitting device 100 is divided into chip units by using an expanding & breaking process. While the embodiments exemplarily describe the light emitting device, such as an LED, the present disclosure may be applied to another semiconductor device that may be formed on the substrate, and the technical features of the present disclosure are not limited to the foregoing embodiments.

In the light emitting device, the insulating member 140 covers the outer periphery of the second semiconductor layer 114, the active layer 120, and the second conductive type semiconductor layer 130. Therefore, although moisture contacts the outer sidewall of the light emitting structure 105, the light emitting region can be protected.

The region between the active layer 120 and the second semiconductor layer 114 and the region between the active layer 120 and the second conductive type semiconductor layer 130 may be formed in the same area. The light emitting structure 105 may be provided in a structure in which the light emitting area is not decreased.

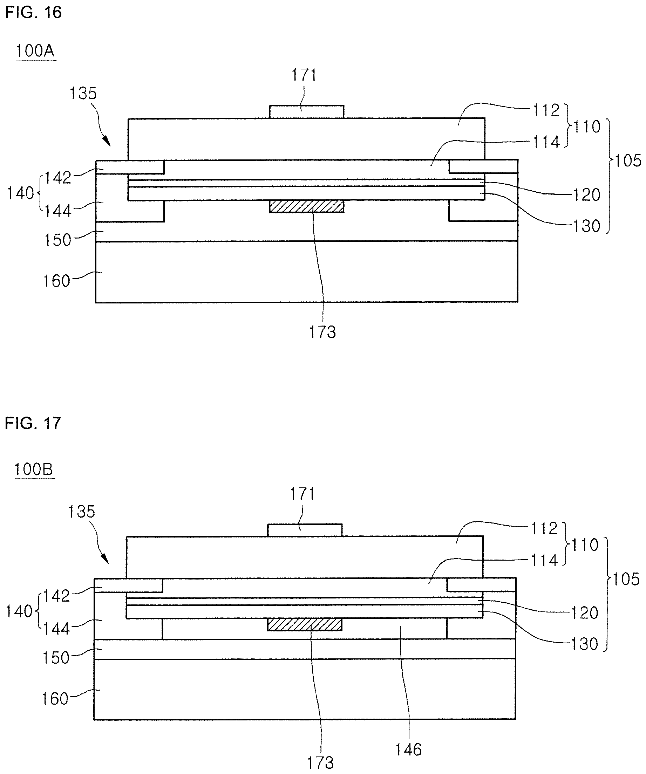

FIG. 16 is a side sectional view of a light emitting device according to a second embodiment. In describing the second embodiment, the same elements as those of the first embodiment will be understood with reference to the first embodiment.

Referring to FIG. 16, a light emitting device 100A may include a current blocking layer 173 between an electrode layer 150 and a light emitting structure 105, and the current blocking layer 173 may be formed of a nonmetallic material having an electrical conductivity lower than the electrode layer 150. The current blocking layer 173 may include at least one selected from the group consisting of ITO, IZO, IZTO, IAZO, IGZO, IGTO, AZO, ATO, ZnO, SiO₂ SiOₓ, SiOₓN_{y}, Si₃N₄, Al₂O₃, and TiO₂. Herein, when the electrode layer 150 is an Ag layer, the current blocking layer 173 may be formed of a material, such as ITO, ZnO, or SiO₂.

The current blocking layer 173 may be formed at a position corresponding to the electrode 171 in a pattern corresponding to the electrodes 171, and the size of the current blocking layer 173 may be changed depending on diffusion degree of the current.

Since the current blocking layer 173 is disposed in a structure corresponding to the electrode 171, the current blocking layer 173 can diffuse the current to the entire region of the chip.

FIG. 17 is a side sectional view of a light emitting device according to a third embodiment. In describing the third embodiment, the same elements as those of the previous embodiment will be understood with reference to the previous embodiment.

Referring to FIG. 17, a light emitting device 100B includes a current blocking layer 173 between an electrode layer 150 and a light emitting structure 105, and an ohmic layer 146 under the second conductive type semiconductor layer 130.

The ohmic layer 146 may be formed of indium tin oxide (ITO), indium zinc oxide (IZO), indium zinc oxide nitride (IZON), indium zinc tin oxide (IZTO), indium aluminum zinc oxide (IAZO), indium gallium zinc oxide (IGZO), indium gallium tin oxide (IGTO), aluminum zinc oxide (AZO), antimony tin oxide (ATO), gallium zinc oxide (GZO), IrOx, RuOx, or RuOx/ITO. The ohmic layer 146 ohmic-contacts the second conductive type semiconductor layer 130 and the electrode layer 150 may be disposed under the ohmic layer 146.

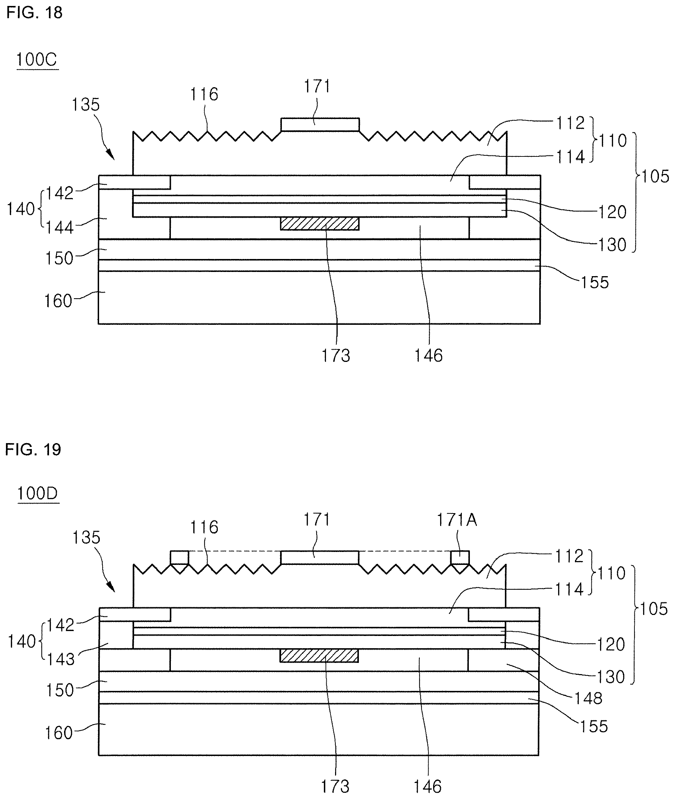

FIG. 18 is a side sectional view of a light emitting device according to a fourth embodiment. In describing the fourth embodiment, the same elements as those of the previous embodiment will be understood with reference to the previous embodiment.

Referring to FIG. 18, a light emitting device 100C may include a bonding layer 155 between an electrode layer 150 and a conductive supporting member 160. The bonding layer 155 contacts a lower surface of the electrode layer 150, and may include a barrier metal or a bonding metal. For example, the bonding layer 155 may include at least one selected from the group consisting of Ti, Au, Sn, Ni, Cr, Ga, In, Bi, Cu, Ag, and Ta.

Also, the first semiconductor layer 112 may have a roughness or an uneven pattern 116 at an upper surface thereof. A lower surface of the electrode 171 may be formed in the roughness or uneven pattern 116, or in a flat surface

FIG. 19 is a side sectional view of a light emitting device according to a fifth embodiment. In describing the fifth embodiment, the same elements as those of the previous embodiment will be understood with reference to the previous embodiment.

Referring to FIG. 19, a light emitting device 100D may include at least one arm electrode 171 A connected to an electrode 171. The electrode 171 and the arm electrode 171 A may disperse and supply current.

In the insulating member 140, the lower surface of the second insulating layer 143 may be copular with the lower surface of the second conductive type semiconductor layer 130. A channel layer 148 may be formed under the second insulating layer 143. The channel layer 148 may include at least one transparent material selected from the group consisting of indium tin oxide (ITO), indium zinc oxide (IZO), indium zinc oxide nitride (IZON), indium zinc tin oxide (IZTO), indium aluminum zinc oxide (IAZO), indium gallium zinc oxide (IGZO), indium gallium tin oxide (IGTO), aluminum zinc oxide (AZO), antimony tin oxide (ATO), and gallium zinc oxide (GZO).

Also, an outer periphery of the first semiconductor layer 112 may be formed in an inclined structure, so that an upper width thereof may be narrower than a lower width thereof.

### <Light emitting device package>

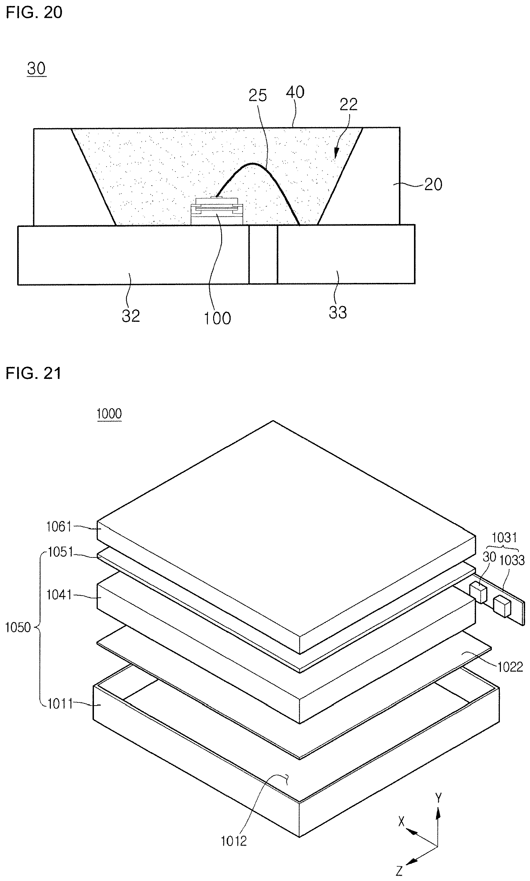

FIG. 20 is a cross-sectional view of a light emitting device package including the light emitting device of FIG. 1.

Referring to FIG. 20, the light emitting device package 30 includes a body 20, first lead electrode 32 and second lead electrode 33 disposed under the body 20, a light emitting device 100 according to the embodiment mounted in the body 20 and electrically connected to the first lead electrode 32 and the second lead electrode 33, and a molding member 40 enclosing the light emitting device 100.

The body 20 may be formed including at least one of a silicon material, a synthetic resin material, a metal material, sapphire (Al₂O₃), and a printed circuit board (PCB), and may have an inclination surface around the light emitting device 100. A cavity 22 may be disposed inside the body 20, and the light emitting device 100 is disposed in the cavity 22.

The first lead electrode 32 and the second lead electrode 33 are electrically separated, and supply power to the light emitting device 100. Also, the first and second lead electrodes 32 and 33 may reflect light generated from the light emitting device 100 to thus increase light efficiency, and may emit heat generated from the light emitting device 100 to an outside.

While FIG. 20 shows that one ends of the first and second lead electrodes 32 and 33 are disposed on the body 20 and the other ends are disposed on the lower surface of the body 20 along an outer side of the body 20, the present disclosure is not limited thereto.

For example, the first and second lead electrodes 32 and 33 may be formed only on the body 20, first and second pads may be formed on the lower surface of the body 20, and the first and second lead electrodes 32 and 33 may be electrically connected to the first and second pads through first and second vias penetrating the body 20.

The light emitting device 100 may be mounted on the body 20, or may be mounted on the first lead electrode 32 or the second lead electrode 33.

While the current embodiment exemplarily shows a wire bonding that the light emitting device 100 is electrically connected to the first lead electrode 32 and the second lead electrode 33 through a wire 25, the present disclosure is not limited thereto. For example, the light emitting device 100 may be electrically connected to the first lead electrode 32 and the second lead electrode 33 by using a flip chip method, or a die bonding method. The light emitting device 100 may be a device having the horizontal structure or vertical structure as disclosed above, but the present disclosure is not limited thereto.

The molding member 40 may be formed of silicon or resin material having light transmittance, and may enclose and protect the light emitting device 100. Also, a fluorescent material may be included in the molding member 40 to change the wavelength of light emitted from the light emitting device 100.

While the current embodiment shows and describes the top view type light emitting device package, the light emitting device package may be implemented by a side view type light emitting device package to provide improved effects in the heat releasing characteristic, conductivity and reflective characteristic. In the top view type or side view type light emitting device package, after the molding member 40 is formed of a resin layer, a lens may be formed or attached on the resin layer, but the present disclosure is not limited thereto.

### <Lighting system>

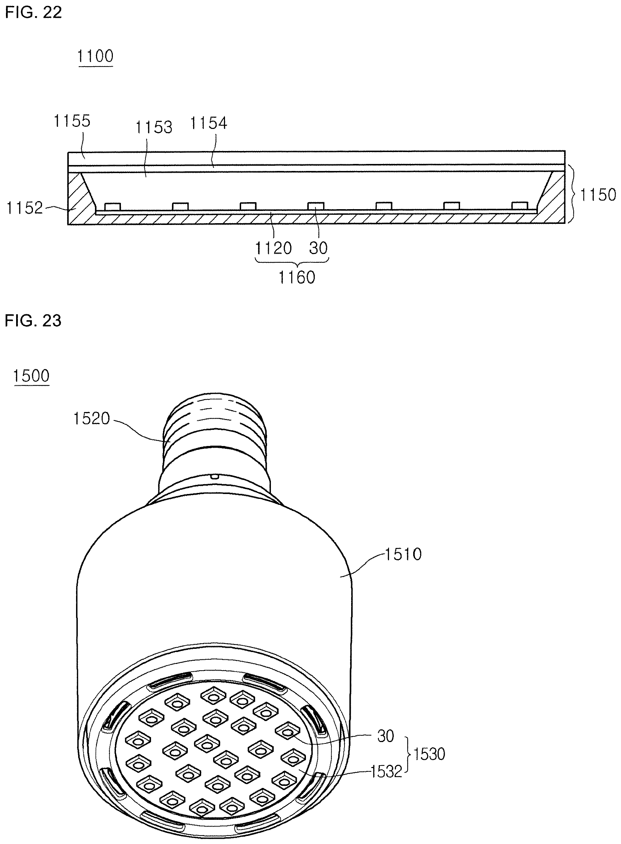

The light emitting devices and the light emitting device packages according to the embodiments may be applied to a light unit. The light unit may have an array structure including a plurality of light emitting devices or a plurality of light emitting device packages, and as shown in FIGs. 21 and 22, may include a lighting apparatus, a lighting lamp, a signal light, a vehicle headlight, an electronic display, etc.

FIG. 21 is a disassembled perspective view of a display apparatus according to an embodiment.

Referring to FIG. 21, the display apparatus 1000 according to the embodiment may include a light guide panel 1041, a light emitting module 1031 supplying light to the light guide panel 1041, a reflective member 1022 under the light guide panel 1041, an optical sheet 1051 on the light guide panel 1041, a display panel 1061 on the optical sheet 1051, and a bottom cover 1011 receiving the light guide panel 1041, the light emitting module 1031, and the reflective member 1022, but the present disclosure is not limited thereto.

The bottom cover 1011, the reflective sheet 1022, the light guide panel 1041, and the optical sheet may be defined as a light unit 1041.

The light guide panel 1041 functions to transform linear light to planar light by diffusing the linear light. The light guide panel 1041 may be made of a transparent material, and may include one of acryl-series resin such as polymethyl metaacrylate (PMMA), polyethylene terephthlate (PET), poly carbonate (PC), COC, and polyethylene naphthalate resin.

The light emitting module 1031 provides light to at least a side surface of the light guide panel 1041, and finally acts as a light source of a display apparatus.

The light emitting module 1031 may include at least one light emitting module, and provide light directly or indirectly from one side surface of the light guide panel 1041. The light emitting module 1031 may include a board 1033, and includes a light emitting device package 30 according to embodiments disclosed above, and the light emitting device packages 30 may be arranged apart by a predetermined interval from each other on the board 1033.

The board 1033 may be a printed circuit board (PCB) including a circuit pattern (not shown). The board 1033 may include a metal core PCB (MCPCB), a flexible PCB (FPCB), etc. as well as the general PCB, but the present disclosure is not limited thereto. In the case where the light emitting device package 30 is mounted on a side surface or a heat releasing plate, the board 1033 may be removed. Herein, some of the heat releasing plate may contact an upper surface of the bottom cover 1011.

The plurality of light emitting device packages 30 may be mounted on the board 1033 such that light emitting surfaces of the plurality of light emitting device packages 30 are spaced apart by a predetermined distance from the light guide panel 1041, but the present disclosure is not limited thereto. The light emitting device package 30 may supply light to a light incident part that is one side surface of the light guide panel 1041, directly or indirectly, but the present disclosure is not limited thereto.

The reflective member 1022 may be provided under the light guide panel 1041. The reflective member 1022 reflects light incident from a lower surface of the light guide panel 1041 to allow the reflected light to be directed toward an upper direction, thereby capable of enhancing brightness of the light unit 1050. The reflective member 1022 may be formed of, for example, PET, PC, PVC resin, or the like, but the present disclosure is not limited thereto.

The bottom cover 1011 may receive the light guide panel 1041, the light emitting module 1031, the reflective member 1022, and the like. For this purpose, the bottom cover 1011 may have a receiving part 1012 formed in a box shape a top surface of which is opened, but the present disclosure is not limited thereto. The bottom cover 1011 may be coupled to a top cover, but the present disclosure is not limited thereto.

The bottom cover 1011 may be formed of a metal material or resin material, and may be manufactured by using a process such as a press molding or an injection molding. Also, the bottom cover 1011 may include metallic or nonmetallic material having a high thermal conductivity, but the present disclosure is not limited thereto.

The display panel 1061 is, for example, an LCD panel, and includes first and second transparent substrates facing each other, and a liquid crystal layer interposed between the first and second substrates. A polarizing plate may be attached on at least one surface of the display panel 1061, but the present disclosure is not limited thereto. The display panel 1061 displays information by using light passing through the optical sheet 1051. The display apparatus 1000 may be applied to a variety of mobile terminals, monitors for notebook computers, monitors for lap-top computers, televisions, etc.

The optical sheet 1051 is disposed between the display panel 1061 and the light guide panel 1041, and includes at least one transparent sheet. The optical sheet 1051 may include, for example, at least one of a diffusion sheet, a horizontal and/or vertical prism sheet, and a brightness reinforcing sheet. The diffusion sheet diffuses incident light, the horizontal and/or vertical prism sheet focuses incident light on a display region, and the brightness reinforcing sheet enhances the brightness by reusing lost light. Also, a protective sheet may be disposed on the display panel 1061, but the present disclosure is not limited thereto. Herein, the display apparatus 1000 may include the light guide panel 1041, and the optical sheet 1051 as optical members positioned on a light path of the light emitting module 1031, but the present disclosure is not limited thereto.

FIG. 22 is a cross-sectional view of a display apparatus according to an embodiment.

Referring to FIG. 22, the display apparatus 1100 includes a bottom cover 1152, a board 1120 on which the light emitting device packages 30 disclosed above are arrayed, an optical member 1154, and a display panel 1155.

The board 1120 and the light emitting device package 30 may be defined as a light emitting module 1060. The bottom cover 1152, the at least one light emitting module 1060, and the optical member 154 may be defined as a light unit.

The bottom cover 1152 may be provided with a receiving part, but the present disclosure is not limited thereto.

Herein, the optical member 1154 may include at least one of a lens, a light guide panel, a diffusion sheet, a horizontal and vertical prism sheet, and a brightness reinforcing sheet. The light guide panel may be formed of polycarbonate (PC) or poly methyl methacrylate (PMMA), and may be removed. The diffusion sheet diffuses incident light, the horizontal and vertical prism sheet focuses incident light on a display region, and the brightness reinforcing sheet enhances the brightness by reusing lost light.

The optical member 1154 is disposed on the light emitting module 1060. The optical member 154 transforms light emitted from the light emitting module 1060 to planar light, and performs diffusion, light focusing, and the like.

FIG. 23 is a perspective view of a lighting unit according to an embodiment.

Referring to FIG. 23, the lighting unit 1500 may include a case 1510, a light emitting module 1530 equipped in the case 1510, and a connection terminal 1520 equipped in the case 1510 and supplied with an electric power from an external power supply.

The case 1510 may be preferably formed of a material having good heat shielding characteristics, for example, a metal material or a resin material.

The light emitting module 1530 may include a board 1532, and at least one light emitting device package 30 according to the embodiments mounted on the board 1532. The light emitting device package 30 may include a plurality of light emitting device packages which are arrayed apart by a predetermined distance from one another in a matrix configuration.

The board 1532 may be an insulator substrate on which a circuit pattern is printed, and may include, for example, a general printed circuit board (PCB), a metal core PCB, a flexible PCB, a ceramic PCB, an FR-4 substrate, etc.

Also, the board 1532 may be formed of a material to efficiently reflect light, and a surface thereof may be formed in a color capable of efficiently reflecting light, for example, white color, or silver color.

The at least one light emitting device packages 200 may be mounted on the board 1532. Each of the light emitting device packages 200 may include at least one light emitting diode (LED) chip. The LED chip may include a color LED emitting red, green, blue or white light, and a UV LED emitting ultraviolet (UV).

The light emitting module 1530 may have a combination of various light emitting device packages so as to obtain desired color and luminance. For example, the light emitting module 1530 may have a combination of a white LED, a red LED, and a green LED so as to obtain a high color rendering index (CRI).

The connection terminal 1520 may be electrically connected to the light emitting module 1530 to supply power. The connection terminal 1520 may be screwed and coupled to an external power in a socket type, but the present disclosure is not limited thereto. For example, the connection terminal 1520 may be made in a pin type and inserted into an external power, or may be connected to the external power through a power line.

The light emitting module of the light unit includes the light emitting device packages. The light emitting device package may have a package structure using the body, or may be prepared by mounting the light emitting devices disclosed above on the board and then packaging the light emitting devices using the molding member.

In one example, a method of manufacturing a light emitting device comprises: forming a first semiconductor layer on a substrate; forming a first insulating layer on an outer periphery of an upper surface of the first semiconductor layer; forming a second semiconductor layer on the first semiconductor layer; forming an active layer and a second conductive type semiconductor layer; exposing an outer periphery of the first insulating layer by using a first etching; forming a second insulating layer from the outer periphery of the first insulating layer to outer upper surfaces of the active layer and the second conductive type semiconductor layer; forming an electrode layer on the second conductive type semiconductor layer and removing the substrate; and forming an electrode under the first semiconductor layer.

According to the embodiments, it is possible to provide LED having good moisture resistance capability, an adhesive force between the light emitting structure and the second electrode layer can be reinforced by using the insulating layer, it is not necessary to form the insulating layer on the entire outer circumferential surface of the light emitting structure, and the electrical reliability of the light emitting structure can be improved.

The characteristics, structures, effects, etc. described in the foregoing embodiments are included in at least one embodiment of the present disclosure, but are not necessarily limited only to one embodiment. Further, the characteristics, structures, effects, etc. described in each of the foregoing embodiments may be embodied through combinations or changes in form with respect to other embodiments by those skilled in the art, to the extent as defined in the appended claims.

Any reference in this specification to 'one embodiment,' 'an embodiment,' 'example embodiment,' etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments, to the extent as falling within the scope of the appended claims.

Although embodiments have been described with reference to a number of illustrative embodiments thereof, it should be understood that numerous other modifications and embodiments can be devised by those skilled in the art that will fall within the scope of the appended claims.

## Claims

1. A light emitting device (100) comprising:
a light emitting structure (105) including a first conductivity type semiconductor layer (110) including a first semiconductor layer (112) and a second semiconductor layer (114) disposed under the first semiconductor layer (112), an active layer (120) disposed under the second semiconductor layer (114), and a second conductivity type semiconductor layer (130) disposed under the active layer (120);
an electrode (171) disposed on an upper surface of the first semiconductor layer (112);
an electrode layer (150) disposed under a lower surface of the second conductivity type semiconductor layer (130);
a conductive supporting member (160) disposed under the electrode layer (150);
a second insulating layer (143, 144) covering a periphery of the second semiconductor layer (114), the active layer (120) and the second conductivity type semiconductor layer (130),
wherein an outer portion of the electrode layer (150) extends under a lower surface of the second insulating layer (144), and
wherein the electrode layer (150) includes a reflective layer,
**characterized in that** a first insulating layer (142) is disposed on a periphery between the first semiconductor layer (112) and the second semiconductor layer (114), the second insulating layer (143, 144) being disposed under the first insulating layer (142), and
**in that** an inner side surface of the first insulating layer (142) which is disposed between the first semiconductor layer (112) and the second semiconductor layer (114) has a concavo-convex structure.

2. The light emitting device of claim 1, wherein a lower portion of the second insulating layer (144) extends into a periphery between the electrode layer (150) and the second conductivity type semiconductor layer (130), wherein the lower portion of the second insulating layer (144) contacts the lower surface of the second conductivity type semiconductor layer (130).

3. The light emitting device of claim 2, wherein the lower portion of the second insulating layer (144) is disposed so as to overlap an inner portion of the first insulating layer (142) in a vertical direction.

4. The light emitting device of any one of claims 1 to 3, wherein a width of a lower surface of the second semiconductor layer (114) is greater than a width of an upper surface of the second semiconductor layer (114).

5. The light emitting device of any one of claims 1 to 4, wherein an outer upper surface of the first insulating layer (142) extends outwardly further than a lower surface of the first semiconductor layer (112).

6. The light emitting device of any one of claims 1 to 5, wherein an inner side surface of the second insulating layer (144) has a concavo-convex structure, and
wherein a concave portion of the concavo-convex structure of the second insulating layer (144) faces a concave portion of the concavo-convex structure of the first insulating layer (142) or in a cross each other.

7. The light emitting device of any one of claims 1 to 6, wherein the first insulating layer (142) and the second insulating layer (143,144) are made of same material.

8. The light emitting device of any one of claims 1 to 7, wherein a dopant concentration of the first semiconductor layer (112) is lower than a dopant concentration of the second semiconductor layer (114).

9. The light emitting device of any one of claims 1 to 8, wherein each of the first semiconductor layer (112) and the second semiconductor layer (114) comprises a semiconductor material having a compositional formula of InₓAl_{y}Ga_{1-x-y}N (0≤x≤1, 0≤y≤1, 0≤x+y≤1), and the semiconductor material of the first semiconductor layer (112) has a refractive index which is higher than that of the semiconductor material of the second semiconductor layer (114).

10. The light emitting device of claim 1, comprising a channel layer (148) on a periphery between the second insulating layer (143) and the electrode layer (150), wherein the channel layer (148) extends between the second conductivity type semiconductor layer (130) and the electrode layer (150).

11. The light emitting device of any one of claims 1 to 10, wherein the first insulating layer (142) and the second insulating layer (143,144) has any one of a frame shape, a ring shape, and a loop shape.

12. The light emitting device of any one of claims 1 to 11, comprising: an ohmic layer (146) between the electrode layer (150) and the second conductivity type semiconductor layer (130); a bonding layer (155) under the electrode layer (150),
wherein the conductive supporting member is disposed under the bonding layer (155).

13. The light emitting device of any one of claims 1 to 12, comprising a current blocking layer (173) overlapping the electrode in a vertical direction between the electrode layer (150) and the second conductive semiconductor layer (130).

14. The light emitting device of any one of claims 1 to 13, wherein the first semiconductor layer (112) has a roughness or uneven pattern, wherein the first conductivity type semiconductor layer (112) is exposed at an upper surface and periphery of the light emitting structure (105).

15. A light emitting device package comprising:
a body (20);
a plurality of lead electrodes (32 and 34) on the body (20);
a light emitting device (100) bonded to one of the plurality of lead electrodes (32 and 34) and electrically connected to the plurality of lead electrodes (32 and 34), wherein the light emitting device (100) is one of the claims 1∼14; and
a molding member (40) molding the light emitting device (100).

## Patentansprüche

1. Lichtemittierende Vorrichtung (100), Folgendes umfassend:
eine lichtemittierende Struktur (105), umfassend eine Halbleiterschicht eines ersten Leitfähigkeitstyps (110), die eine erste Halbleiterschicht (112) und eine unter der ersten Halbleiterschicht (112) angeordnete zweite Halbleiterschicht (114) umfasst, eine unter der zweiten Halbleiterschicht (114) angeordnete aktive Schicht (120) und eine unter der aktiven Schicht (120) angeordnete Halbleiterschicht eines zweiten Leitfähigkeitstyps (130);
eine Elektrode (171), die auf einer oberen Oberfläche der ersten Halbleiterschicht (112) angeordnet ist;
eine Elektrodenschicht (150), die unter einer unteren Oberfläche der Halbleiterschicht des zweiten Leitfähigkeitstyps (130) angeordnet ist;
ein leitfähiges Trägerelement (160), das unter der Elektrodenschicht (150) angeordnet ist; eine zweite Isolierschicht (143,144), die einen Randbereich der zweiten Halbleiterschicht (114), der aktiven Schicht (120) und der Halbleiterschicht des zweiten Leitfähigkeitstyps (130) bedeckt,
wobei sich ein Außenabschnitt der Elektrodenschicht (150) unter einer unteren Oberfläche der zweiten Isolierschicht (144) erstreckt, und
wobei die Elektrodenschicht (150) eine reflektierende Schicht umfasst,
**dadurch gekennzeichnet, dass** eine erste Isolierschicht (142) auf einem Randbereich zwischen der ersten Halbleiterschicht (112) und der zweiten Halbleiterschicht (114) angeordnet ist, wobei die zweite Isolierschicht (143, 144) unter der ersten Isolierschicht (142) angeordnet ist, und
dadurch, dass eine seitliche Innenoberfläche der ersten Isolierschicht (142), die zwischen der ersten Halbleiterschicht (112) und der zweiten Halbleiterschicht (114) angeordnet ist, eine konkav-konvexe Struktur aufweist.

2. Lichtemittierende Vorrichtung nach Anspruch 1, wobei sich ein unterer Abschnitt der zweiten Isolierschicht (144) in einen Randbereich zwischen der Elektrodenschicht (150) und der Halbleiterschicht des zweiten Leitfähigkeitstyps (130) erstreckt,
wobei der untere Abschnitt der zweiten Isolierschicht (144) die untere Oberfläche der Halbleiterschicht des zweiten Leitfähigkeitstyps (130) berührt.

3. Lichtemittierende Vorrichtung nach Anspruch 2, wobei der untere Abschnitt der zweiten Isolierschicht (144) so angeordnet ist, dass er einen inneren Abschnitt der ersten Isolierschicht (142) in einer vertikalen Richtung überlappt.

4. Lichtemittierende Vorrichtung nach einem der Ansprüche 1 bis 3, wobei eine Breite einer unteren Oberfläche der zweiten Halbleiterschicht (114) größer als eine Breite einer oberen Oberfläche der zweiten Halbleiterschicht (114) ist.

5. Lichtemittierende Vorrichtung nach einem der Ansprüche 1 bis 4, wobei sich eine obere Außenoberfläche der ersten Isolierschicht (142) weiter nach außen erstreckt als eine untere Oberfläche der ersten Halbleiterschicht (112).

6. Lichtemittierende Vorrichtung nach einem der Ansprüche 1 bis 5, wobei eine seitliche Innenoberfläche der zweiten Isolierschicht (144) eine konkav-konvexe Struktur aufweist, und
wobei ein konkaver Abschnitt der konkav-konvexen Struktur der zweiten Isolierschicht (144) einem konkaven Abschnitt der konkav-konvexen Struktur der ersten Isolierschicht (142) zugewandt ist oder sie ineinander übergreifend angeordnet sind.

7. Lichtemittierende Vorrichtung nach einem der Ansprüche 1 bis 6, wobei die erste Isolierschicht (142) und die zweite Isolierschicht (143, 144) aus demselben Material hergestellt sind.

8. Lichtemittierende Vorrichtung nach einem der Ansprüche 1 bis 7, wobei eine Dotierungskonzentration der ersten Halbleiterschicht (112) niedriger als eine Dotierungskonzentration der zweiten Halbleiterschicht (114) ist.

9. Lichtemittierende Vorrichtung nach einem der Ansprüche 1 bis 8, wobei jede der ersten Halbleiterschicht (112) und der zweiten Halbleiterschicht (114) ein Halbleitermaterial umfasst, das eine Zusammensetzungsformel von InₓAl_{y}Ga_{1-x-y}N (0≤x≤1, 0≤y≤1, 0≤x+y≤1) aufweist, und das Halbleitermaterial der ersten Halbleiterschicht (112) einen Brechnungsindex aufweist, der höher als jener des Halbleitermaterials der zweiten Halbleiterschicht (114) ist.

10. Lichtemittierende Vorrichtung nach Anspruch 1, umfassend eine Kanalschicht (148) auf einem Randbereich zwischen der zweiten Isolierschicht (143) und der Elektrodenschicht (150), wobei sich die Kanalschicht (148) zwischen der Halbleiterschicht des zweiten Leitfähigkeitstyps (130) und der Elektrodenschicht (150) erstreckt.

11. Lichtemittierende Vorrichtung nach einem der Ansprüche 1 bis 10, wobei die erste Isolierschicht (142) und die zweite Isolierschicht (143, 144) eine einer Rahmenform, einer Ringform und einer Schleifenform aufweist.

12. Lichtemittierende Vorrichtung nach einem der Ansprüche 1 bis 11, Folgendes umfassend: eine ohmsche Schicht (146) zwischen der Elektrodenschicht (150) und der Halbleiterschicht des zweiten Leitfähigkeitstyps (130); eine Haftschicht (155) unter der Elektrodenschicht (150), wobei das leitfähige Trägerelement unter der Haftschicht (155) angeordnet ist.

13. Lichtemittierende Vorrichtung nach einem der Ansprüche 1 bis 12, umfassend eine Stromblockierschicht (173), die die Elektrode in einer vertikalen Richtung zwischen der Elektrodenschicht (150) und der Halbleiterschicht des zweiten Leitfähigkeitstyps (130) überlappt.

14. Lichtemittierende Vorrichtung nach einem der Ansprüche 1 bis 13, wobei die erste Halbleiterschicht (112) ein raues oder unebenes Muster aufweist,
wobei die Halbleiterschicht des ersten Leitfähigkeitstyps (112) auf einer oberen Oberfläche und einem Randbereich der lichtemittierenden Struktur (105) freiliegt.

15. Gehäuse für eine lichtemittierende Vorrichtung, Folgendes umfassend:
einen Körper (20);
eine Mehrzahl von Bleielektroden (32 und 34) auf dem Körper (20);
eine lichtemittierende Vorrichtung (100), die an eine der Mehrzahl von Bleielektroden (32 und 34) gebondet ist und mit der Mehrzahl von Bleielektroden (32 und 34) elektrisch verbunden ist, wobei die lichtemittierende Vorrichtung (100) nach einem der Ansprüche 1 bis 14 definiert ist; und
ein Formungselement (40), das die lichtemittierende Vorrichtung (100) formt.

## Revendications

1. Dispositif électroluminescent (100) comprenant :
une structure électroluminescente (105) comportant une couche semi-conductrice de premier type de conductivité (110) comportant une première couche semi-conductrice (112) et une seconde couche semi-conductrice (114) disposée sous la première couche semi-conductrice (112), une couche active (120) disposée sous la seconde couche semi-conductrice (114), et une couche semi-conductrice de second type de conductivité (130) disposée sous la couche active (120) ;
une électrode (171) disposée sur une surface supérieure de la première couche semi-conductrice (112) ;
une couche d'électrode (150) disposée sous une surface inférieure de la couche semi-conductrice de second type de conductivité (130) ;
un organe de support conducteur (160) disposé sous la couche d'électrode (150) ;
une seconde couche isolante (143, 144) couvrant une périphérie de la seconde couche semi-conductrice (114), la couche active (120) et la couche semi-conductrice de second type de conductivité (130),
dans lequel une portion extérieure de la couche d'électrode (150) s'étend sous une surface inférieure de la seconde couche isolante (144), et
dans lequel la couche d'électrode (150) comporte une couche réfléchissante,
**caractérisé en ce qu'**une première couche isolante (142) est disposée sur une périphérie entre la première couche semi-conductrice (112) et la seconde couche semi-conductrice (114), la seconde couche isolante (143, 144) étant disposée sous la première couche isolante (142), et
**en ce qu'**une surface latérale intérieure de la première couche isolante (142) qui est disposée entre la première couche semi-conductrice (112) et la seconde couche semi-conductrice (114) a une structure concavo-convexe.

2. Dispositif électroluminescent selon la revendication 1, dans lequel une portion inférieure de la seconde couche isolante (144) s'étend dans une périphérie entre la couche d'électrode (150) et la couche semi-conductrice de second type de conductivité (130),
dans lequel la portion inférieure de la seconde couche isolante (144) vient en contact avec la surface inférieure de la couche semi-conductrice de second type de conductivité (130).

3. Dispositif électroluminescent selon la revendication 2, dans lequel la portion inférieure de la seconde couche isolante (144) est disposée de façon à chevaucher une portion intérieure de la première couche isolante (142) dans une direction verticale.

4. Dispositif électroluminescent selon l'une quelconque des revendications 1 à 3, dans lequel une largeur d'une surface inférieure de la seconde couche semi-conductrice (114) est plus grande qu'une largeur d'une surface supérieure de la seconde couche semi-conductrice (114).

5. Dispositif électroluminescent selon l'une quelconque des revendications 1 à 4, dans lequel une surface supérieure extérieure de la première couche isolante (142) s'étend davantage vers l'extérieur qu'une surface inférieure de la première couche semi-conductrice (112).

6. Dispositif électroluminescent selon l'une quelconque des revendications 1 à 5, dans lequel une surface latérale intérieure de la seconde couche isolante (144) a une structure concavo-convexe, et
dans lequel une portion concave de la structure concavo-convexe de la seconde couche isolante (144) fait face à une portion concave de la structure concavo-convexe de la première couche isolante (142) ou se croisent l'une l'autre.

7. Dispositif électroluminescent selon l'une quelconque des revendications 1 à 6, dans lequel la première couche isolante (142) et la seconde couche isolante (143, 144) sont constituées du même matériau.

8. Dispositif électroluminescent selon l'une quelconque des revendications 1 à 7, dans lequel une concentration en dopant de la première couche semi-conductrice (112) est inférieure à une concentration en dopant de la seconde couche semi-conductrice (114).

9. Dispositif électroluminescent selon l'une quelconque des revendications 1 à 8, dans lequel chacune de la première couche semi-conductrice (112) et de la seconde couche semi-conductrice (114) comprend un matériau semi-conducteur ayant une formule de composition de InₓAl_{y}Ga_{1-x-y}N (0≤x≤1, 0≤y≤1, 0≤x+y≤1), et le matériau semi-conducteur de la première couche semi-conductrice (112) a un indice de réfraction qui est plus élevé que celui du matériau semi-conducteur de la seconde couche semi-conductrice (114).

10. Dispositif électroluminescent selon la revendication 1, comprenant une couche de canal (148) sur une périphérie entre la seconde couche isolante (143) et la couche d'électrode (150), dans lequel la couche de canal (148) s'étend entre la couche semi-conductrice de second type de conductivité (130) et la couche d'électrode (150).

11. Dispositif électroluminescent selon l'une quelconque des revendications 1 à 10, dans lequel la première couche isolante (142) et la seconde couche isolante (143, 144) ont l'une quelconque parmi une forme de cadre, une forme d'anneau, et une forme de boucle.

12. Dispositif électroluminescent selon l'une quelconque des revendications 1 à 11, comprenant: une couche ohmique (146) entre la couche d'électrode (150) et la couche semi-conductrice de second type de conductivité (130) ; une couche liante (155) sous la couche d'électrode (150),
dans lequel l'organe de support conducteur est disposé sous la couche liante (155).

13. Dispositif électroluminescent selon l'une quelconque des revendications 1 à 12, comprenant une couche de blocage de courant (173) chevauchant l'électrode dans une direction verticale entre la couche d'électrode (150) et la seconde couche semi-conductrice conductrice (130).

14. Dispositif électroluminescent selon l'une quelconque des revendications 1 à 13, dans lequel la première couche semi-conductrice (112) a une rugosité ou un motif irrégulier,
dans lequel la couche semi-conductrice de premier type de conductivité (112) est exposée au niveau d'une surface supérieure et d'une périphérie de la structure électroluminescente (105).

15. Boîtier de dispositif électroluminescent comprenant :
un corps (20) ;
une pluralité d'électrodes en plomb (32 et 34) sur le corps (20) ;
un dispositif électroluminescent (100) lié à l'une de la pluralité d'électrodes en plomb (32 et 34) et connecté électriquement à la pluralité d'électrodes en plomb (32 et 34), dans lequel le dispositif électroluminescent (100) est celui des revendications 1 à 14 ; et
un organe de moulage (40) moulant le dispositif électroluminescent (100).
